# EUROPEAN PATENT APPLICATION

(11) **EP 4 674 678 A1**
(43) Date of publication of application: **07.01.2026**
(21) Application number: 24891546.4
(22) Date of filing: 06.03.2024
(51) Int. Cl.: B60L 58/16, B60L 3/12, G01R 31/392, G01R 31/396, G01R 31/367, G01R 31/382, G06N 20/00

(54) **METHOD AND SYSTEM FOR EVALUATING LIFE OF BATTERY THROUGH AI-BASED ELECTRIC VEHICLE OPERATION DATA ANALYSIS**

(30) Priority: 13.11.2023 KR 20230156158
(71) Applicant: Batterfly Inc., Ltd., Seoul 05022 (KR)
(72) Inventor: PARK, Sungwon, Seoul 04742 (KR)
(74) Representative: Mewburn Ellis LLP
(86) International application number: PCT/KR2024/002849
(87) International publication number: WO 2025/105597

(57) **Abstract**

According to one embodiment of the present invention, there is provided a battery life evaluation system including: a data collection unit configured to obtain information about route information, charge/discharge patterns, driving patterns, and cell states from an electric vehicle; and a life evaluation unit configured to predict the life of a battery installed in the electric vehicle by performing machine learning based on the obtained information.

## Description

### Technical Field

The present invention relates to a method and system for evaluating battery life through AI-based electric vehicle driving data analysis.

### Background Art

Vehicles can be equipped with various devices that operate by consuming electricity, and batteries are provided to store electricity to be provided to the various devices. Recently, electric vehicles that generate the output of the vehicles by using batteries are on the rise.

A vehicle battery is the most important component among various elements that constitute an electric vehicle, and the possible driving distance and the maximum motor output are determined based on the capacity and voltage of the vehicle battery. Since the vehicle battery is not separated from the vehicle after being installed in the vehicle unless it has a serious impact on driving, the deterioration state thereof cannot be checked. Therefore, technology for diagnosing the life and state of an electric vehicle battery that are directly related to the performance, reliability, and safety of the electric vehicle is considerably important.

In the case of conventional methods for diagnosing the life and state of a battery, most of them estimate the life and state of a battery by applying some data based on lithium-ion battery deterioration models.

The items described as background technology above are only intended to enhance the understanding of the background of the present invention, and should not be accepted as acknowledging that they correspond to conventional technology already known to those having ordinary skill in the art.

### Disclosure

### Technical Problem

Objects of the present invention are to overcome the problems of the conventional technologies described above.

An object of the present invention is to accurately predict battery life by analyzing 17 factors affecting the battery life through the differential application of a weight according to the degree of influence of each of the factors.

An object of the present invention is to, when the battery life of an electric vehicle is below an average with respect to a total travel distance, provide information about a life improvement suggestion to a user terminal of a user related to the corresponding electric vehicle.

The objects of the present invention are not limited to those mentioned above, and other objects not mentioned will be clearly understood from the following description.

### Technical Solution

According to one embodiment of the present invention for achieving the above-described objects, there is provided a battery life evaluation system including: a data collection unit configured to obtain information about route information, charge/discharge patterns, driving patterns, and cell states from an electric vehicle; and a life evaluation unit configured to predict the life of a battery installed in the electric vehicle by performing machine learning based on the obtained information.

The route information may be the total travel distance of the electric vehicle during a first period; the charge/discharge patterns may be an average DOD during a second period, an average discharge C-RATE during the second period, a cumulative discharge during the second period, a cumulative required drivetrain power during the second period, an average required drivetrain power during the second period, and an average SOC; the driving patterns may be an average speed during the second period, an average speed change per second during the second period, and an average accelerator pedal position, number of sudden accelerations, number of sudden decelerations, number of sudden stops and heater operation time during the second period; and the cell states may be an average cell voltage difference per second, cell max average temperature and cell min average temperature during the second period.

In the machine learning, weights of 0.28, 0.1, 0.22, 0.13, 0.11, 0.23, 0.07, 0.07, 0.08, 0.10, 0.12, 0.20, 1.00, 0.31, 0.45, 0.30, and 0.03 may be applied to the total travel distance of the electric vehicle during the first period, the average DOD during the second period, the average discharge C-RATE during the second period, the cumulative discharge during the second period, the cumulative required drivetrain power during the second period, the average required drivetrain power during the second period, the average SOC, the average speed during the second period, the average speed change per second during the second period, the average accelerator pedal position, number of sudden accelerations, number of sudden decelerations, number of sudden stops and heater operation time during the second period, and the average cell voltage difference per second, cell max average temperature and cell min average temperature during the second period, respectively.

The machine learning may employ the Random Forest algorithm.

### Advantageous Effects

According to one embodiment, battery life may be accurately predicted by analyzing the 17 factors affecting the battery life through the differential application of a weight according to the degree of influence of each of the factors.

According to one embodiment, when the battery life of an electric vehicle is below an average with respect to a total travel distance, information about a life improvement suggestion may be provided to a user terminal of a user related to the corresponding electric vehicle.

### Description of Drawings

FIG. 1 is a diagram showing the configuration of a battery life evaluation system according to one embodiment of the present invention;
FIG. 2 shows the results of analyzing whether there were significant differences or changes between vehicles and during a driving period for each of the factors recorded and managed during electric bus operation in order to identify factors affecting battery life according to one embodiment of the present invention; and
FIG. 3 is a diagram showing the learning results of machine learning algorithms.

### Mode for Invention

The following detailed description of the present invention refers to the accompanying drawings, which illustrate specific embodiments in which the present invention may be practiced. These embodiments will be described in sufficient detail to enable those skilled in the art to practice the present invention. It should be understood that the various embodiments of the present invention are different from each other but are not necessarily mutually exclusive. For example, specific shapes, structures, and features described herein may be implemented in other embodiments without departing from the spirit and scope of the present invention. It should also be understood that the locations or arrangement of individual components within each disclosed embodiment may be changed without departing from the spirit and scope of the present invention. Accordingly, the detailed description to be given below is not taken in limiting senses. The scope of the present invention is defined only by the appended claims, along with the full scope of equivalents to the claims, if appropriately so described. In the drawings, like reference characters designate the same or similar functions throughout various aspects.

Hereinafter, in order to enable a person having ordinary skill in the art to which the present invention pertains to easily practice the present invention, preferred embodiments of the present invention will be described in detail with reference to the accompanying drawings.

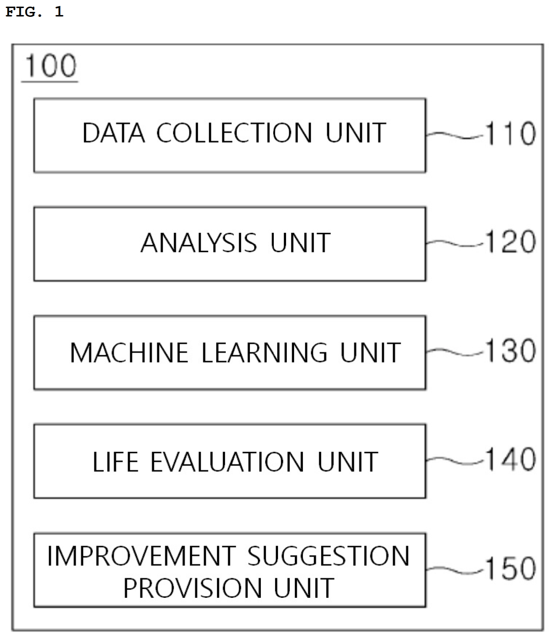

FIG. 1 is a diagram showing the configuration of a battery life evaluation system according to one embodiment of the present invention.

Referring to FIG. 1, a battery life evaluation system 100 according to one embodiment may be configured to include a data collection unit 110, an analysis unit 120, a machine learning unit 130, a life evaluation unit 140, and an improvement suggestion provision unit 150.

The life evaluation system 100 according to the one embodiment may be implemented as a known terminal or server. The terminal may be implemented in any form as long as it is a device that has a computational function and can communicate with the outside.

The data collection unit 110, the analysis unit 120, the machine learning unit 130, the life evaluation unit 140, and the improvement suggestion provision unit 150 may be program modules or hardware that can communicate with an external device. These program modules or hardware may be included in the life evaluation system 100 or another apparatus capable of communicating with the life evaluation system 100 in the form of an operating system, application program modules, and other program modules, and may be physically stored on various known memory devices. Meanwhile, these program modules or hardware include, but are not limited to, routines, subroutines, programs, objects, components, data structures, etc. that perform specific tasks to be described below or execute specific abstract data types according to the present invention.

The data collection unit 110 collects data, shown in the following table, from a vehicle equipped with a battery, e.g., an electric bus, which is a life evaluation target.

According to one embodiment of the present invention, hundreds of factors that may be collected from batteries or electric vehicles powered by batteries were analyzed for their correlation with battery life. The analysis was performed using algorithms such as machine learning, with the result that 17 factors having the highest correlation with battery life were extracted.

The individual items marked as "factor" in Table 1 below are factors collected from each electric bus, and a total of 17 factors described above are collected.

Furthermore, Table 1 below provides information about categories (route information, charge/discharge patterns, driving patterns, cell states, and targets) for the individual factors and how (sum or average) data for a corresponding factor is collected for each period unit (day or week).

**[Table 1]**

| CATEGORY | DAILY AGGREGATION | WEEKLY AGGREGATION | ITEM | FACTOR |
|---|---|---|---|---|
| ROUTE INFORMATION | SUM | SUM | DISTANCE | Total Travel Distance (weekly) |
| CHARGE/DISCHARGE PATTERNS | AVERAGE | AVERAGE | DOD | Average Daily DOD (Max - Min) |
| | AVERAGE | AVERAGE | C_RATE | Average Daily Discharge C-RATE |
| | SUM | SUM | DCH_DOD | Cumulative Daily Discharge |
| | SUM | SUM | DRIVE_POWER_SUM | Cumulative Required Drivetrain Power |
| | AVERAGE | AVERAGE | DRIVE_POWER_P | Average Required Drivetrain Power |
| | | | | (0 or higher) |
| | AVERAGE | AVERAGE | SOC | Average SOC |
| DRIVING PATTERNS | AVERAGE | AVERAGE | SPEED | Average Daily Speed (speed 0 or higher) |
| | AVERAGE | AVERAGE | DIFF_SPEED | Average Daily Speed Change per Second |
| | AVERAGE | AVERAGE | ACC_POS | Average Daily Accelerator Pedal Position (pos 0 or higher) |
| | SUM | SUM | ACC | Number of Sudden Accelerations |
| | SUM | SUM | DEC | Number of Sudden Decelerations |
| | SUM | SUM | DEC_STOP | Number of Sudden Stops |
| | SUM | SUM | EVCU | Heater on Count (seconds) |
| CELL STATES | AVERAGE | AVERAGE | CELL_DIFF | Average Daily Cell Voltage Difference per Second |
| | AVERAGE | AVERAGE | CELL_MXTMP | Cell Max Average Temperature |
| | AVERAGE | AVERAGE | CELL_MNTMP | Cell Min Average Temperature |

In the table above, DOD (Depth of Discharge) is an indicator of the discharge state of the battery, and is an indicator of how much the battery is currently discharged based on a fully charged state. Furthermore, C-RATE (Current Rate) is a value indicating the speed at which the battery is charged or discharged. The accelerator pedal position is related to the representation of a driver's intention to drive, and is a value indicating 0% when the accelerator pedal is not pressed in the state in which the ignition is turned on and 100% when the accelerator pedal is fully pressed.

The sudden acceleration means accelerating at a speed rate of 5 to 8 km/h per second (5 km/h per second for a truck, 6 km/h per second for a bus, and 8 km/h per second for a tax) from a speed of 6.0 km/h or higher, and the sudden deceleration means decelerating at a speed rate of 8 to 14 km/h per second (8 km/h per second for a truck, 9 km/h per second for a bus, and 14 km/h per second for a tax) and then driving at a speed of 6.0 km/h or higher. Furthermore, the sudden stop means decelerating at a speed rate of 8 to 14 km/h per second (8 km/h per second for a truck, 9 km/h per second for a bus, and 14 km/h per second for a tax) or higher and then driving at a speed of 5.0 km/h or lower.

The heater on count is defined as the time for which the vehicle heater is operated. According to one embodiment, the heater on count is defined as the cumulative heater operation time for a day or a week, and the unit thereof may be "seconds."

The cell max average temperature is the average value of the maximum temperatures of a plurality of cells present in the battery, and the cell min average temperature is the average value of the minimum temperatures of the plurality of cells present in the battery.

The analysis unit 120 performs a function of analyzing whether each of the above 17 factors is correlated with the battery life, i.e., SOH, to some degree.

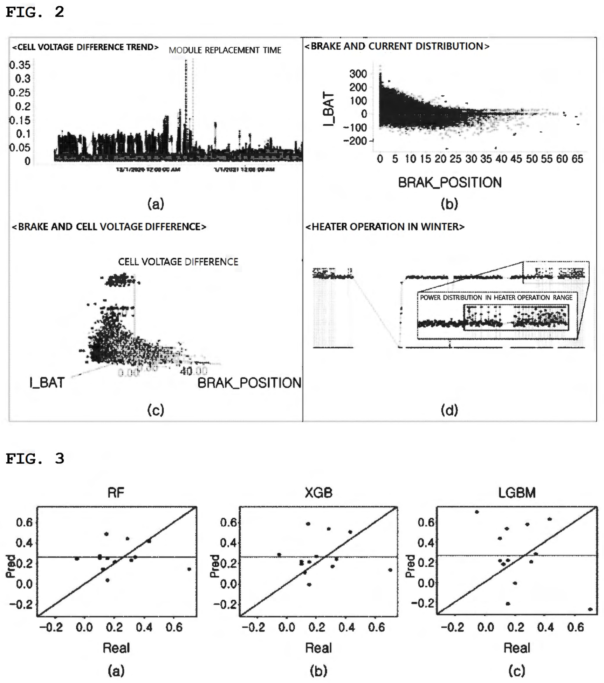

For example, FIG. 2 shows the results of analyzing whether there were significant differences or changes between vehicles and during a driving period for each of the factors recorded and managed during electric bus operation in order to identify factors affecting battery life according to one embodiment of the present invention.

Referring to FIG. 2(a), it can be seen that the cell voltage difference was stabilized after the battery module had been replaced, and, referring to FIG. 2(b), it can be seen that the brake discharge current and the charge current alternated rapidly during driving and more charge current was generated when the brake was lightly pressed.

Furthermore, referring to FIG. 2(c), it can be seen that the braking during driving caused the charge and discharge to alternate rapidly, thereby making the cell voltage difference large. That is, it can be seen that the cell voltage difference is an influential factor on the battery life.

Referring to FIG. 2(d), it can be seen that about 11 kW of power was consumed when the heater is in operation and whether or not the heater is in operation is also an influential factor on the battery life.

The analysis unit 120 analyzes the degree of correlation between each of the extracted factors and the battery life through the above analysis.

The machine learning unit 130 according to the embodiment performs learning on the relationships between the 17 factors and the battery life based on the results obtained through the analysis of the analysis unit 120. Through this, the degree to which each of the 17 factors affects the battery life, i.e., the degree of influence, is analyzed.

The applicant performed the above learning based on the Random Forest, XGB, and Light GBM algorithms out of machine learning algorithms, and the results are as shown in FIG. 3.

FIGS. 3(a) to 3(c) show the results of learning performed based on the Random Forest, XGB, and Light GBM algorithms, respectively. In each graph, the horizontal axis represents the real value, and the vertical axis represents the predicted value.

As can be seen from FIG. 3, it can be seen that the Random Forest algorithm produced the predicted value having the smallest deviation from the real value.

Accordingly, in one embodiment, the influence of each factor was analyzed through the learning of the relationships between the 17 factors and the battery life based on the Random Forest algorithm, and the results thereof are as follows:

**[Table 2]**

| CATEGORY | FACTOR | INFLUENCE DIRECTIONALITY | INFLUENCE DETAILS | DEGREE OF INFLUENCE |
|---|---|---|---|---|
| ROUTE INFORMATION | Total Travel Distance (weekly) | | SOH degradation accelerates when travel distance increases after 1400 km per week | 0.28 |
| CELL STATES | Average Daily Cell Voltage Difference per Second | - | SOH degradation accelerates more as cell voltage difference increases | 0.45 |
| | Cell max Average Temperature | Range | SOH degradation is less in the cell max temperature range of 25 to 30 degrees | 0.30 |
| | Cell Min Average Temperature | + | SOH degradation is less in the cell max temperature range of 25 to 30 degrees | 0.03 |
| DRIVING PATTERNS | Number of Sudden Stops | - | SOH degradation accelerates when the number of sudden stops increases | 1.00 |
| | Heater on Count (Seconds) | - | SOH degradation accelerates when heater usage time increases | 0.31 |
| | Number of Sudden Decelerations | - | SOH degradation accelerates when the number of sudden decelerations increases | 0.20 |
| | Number of Sudden Accelerations | - | SOH degradation accelerates in the range of 0 to 500 | 0.12 |
| | Average Daily Accelerator Pedal Position | - | SOH degradation accelerates in the ranges of 15 to 20 and 35 to 40 | 0.10 |
| | Average Daily Speed Change per Second | - | SOH degradation accelerates when the number of sudden accelerations increases | 0.08 |
| | Average Daily Speed (speed 0 or higher) | + | | 0.07 |
| CHARGE /DIS-CHARGE PATTERNS | Average Required Drivetrain Power (0 or higher) | Range | SOH degradation is less in the range of 30 to 40 Kwh | 0.23 |
| | Average Daily Discharge C-RATE | - | SOH degradation accelerates when C-rate increases | 0.22 |
| | Cumulative Discharge | | SOH degradation accelerates when the cumulative discharge increases | 0.13 |
| | Cumulative Required Drivetrain Power | - | SOH degradation accelerates when the cumulative required drivetrain power increases | 0.11 |
| | Average Daily DOD (Max - Min) | - | SOH degradation accelerates when daily average DOD is deeply used | 0.10 |
| | Average SOC | + | | 0.07 |

The life evaluation unit 140 applies the degree of influence of each of the 17 factors, obtained above, as a weight. That is, the life of the battery equipped in a specific electric vehicle, i.e., SOH, may be predicted by obtaining the 17 factors from the electric vehicle, e.g., an electric bus, and then performing machine learning with the weight applied to each factor. The improvement suggestion provision unit 150 performs a function of providing an improvement suggestion when the evaluated life is below an average with respect to a total travel distance. Among the 17 factors described above, the charge/discharge patterns and the driving patterns are factors that may have positive effects on the battery life by improving them.

Accordingly, there may be provided information about the fact that improvements are required for the factors causing SOH degradation acceleration in Table 2 above. The information may be provided to a user terminal (not shown) capable of communicating with the system 100 according to one embodiment.

According to one embodiment, battery life may be accurately predicted by analyzing the 17 factors affecting the battery life through the differential application of a weight according to the degree of influence of each of the factors.

According to one embodiment, when the battery life of an electric vehicle is below an average with respect to a total travel distance, information about a life improvement suggestion may be provided to a user terminal of a user related to the corresponding electric vehicle.

The foregoing description of the present invention is intended for illustrative purposes, and those skilled in the art will understand that it may be easily modified into other specific forms without departing from the technical spirit or essential features of the present invention. Therefore, it should be understood that the embodiments described above are illustrative but not limitative in all respects. For example, each component described as a single type may be implemented in a distributed form, and likewise, components described as distributed may be implemented in a combined form.

The scope of the present invention is defined by the claims to be described below, and all alterations or modifications derived from the meanings and scope of the claims and their equivalents should be interpreted as being included in the scope of the present invention.

## Claims

1. A battery life evaluation system comprising:
a data collection unit configured to obtain information about route information, charge/discharge patterns, driving patterns, and cell states from an electric vehicle; and
a life evaluation unit configured to predict life of a battery installed in the electric vehicle by performing machine learning based on the obtained information.

2. The battery life evaluation system of claim 1, wherein:
the route information is a total travel distance of the electric vehicle during a first period;
the charge/discharge patterns are an average DOD during a second period, an average discharge C-RATE during the second period, a cumulative discharge during the second period, a cumulative required drivetrain power during the second period, an average required drivetrain power during the second period, and an average SOC;
the driving patterns are an average speed during the second period, an average speed change per second during the second period, and an average accelerator pedal position, number of sudden accelerations, number of sudden decelerations, number of sudden stops and heater operation time during the second period; and
the cell states are an average cell voltage difference per second, cell max average temperature and cell min average temperature during the second period.

3. The battery life evaluation system of claim 2, wherein:
in the machine learning,
weights of 0.28, 0.1, 0.22, 0.13, 0.11, 0.23, 0.07, 0.07, 0.08, 0.10, 0.12, 0.20, 1.00, 0.31, 0.45, 0.30, and 0.03 are applied to the total travel distance of the electric vehicle during the first period, the average DOD during the second period, the average discharge C-RATE during the second period, the cumulative discharge during the second period, the cumulative required drivetrain power during the second period, the average required drivetrain power during the second period, the average SOC, the average speed during the second period, the average speed change per second during the second period, the average accelerator pedal position, number of sudden accelerations, number of sudden decelerations, number of sudden stops and heater operation time during the second period, and the average cell voltage difference per second, cell max average temperature and cell min average temperature during the second period, respectively.

4. The battery life evaluation system of claim 1, wherein the machine learning employs a Random Forest algorithm.
